# EUROPEAN PATENT APPLICATION

(11) **EP 3 255 365 A1**
(43) Date of publication of application: **13.12.2017**
(21) Application number: 16173726.7
(22) Date of filing: 09.06.2016
(51) Int. Cl.: F25J 1/02, G06F 1/20, H05K 7/14, B63B 35/44

(54) **SYSTEM AND METHOD FOR OFFSHORE PROCESSING OF HYDROCARBONS**

(71) Applicant: Shell Internationale Research Maatschappij B.V., 2596 HR Den Haag (NL)
(72) Inventor: Beauregard, Stanislas Yves, 2288 GC Rijswijk (NL); Dabkowski, Marcel Filip, 2288 GC Rijswijk (NL)
(74) Representative: Matthezing, Robert Maarten

(57) **Abstract**

The present application provides a system for offshore processing of hydrocarbons, the system comprising:
- at least one offshore structure, the offshore structure being provided with:
- at least one power plant unit (74) for converting the hydrocarbons to electrical power;
- a cooling water intake system (52) for taking in cooling water from a body of water;
- at least one data centre unit (80) being powered by at least part of the electrical power;
- at least one power cable (22) to transport another part of the electrical power to shore; and
- at least one data line (26) for transferring data between the at least one offshore structure and shore.

## Description

### BACKGROUND OF THE INVENTION

The present disclosure relates to a system and method for offshore processing of hydrocarbons. The hydrocarbons herein for instance comprise at least natural gas. The gas typically originates from offshore hydrocarbon production wells.

Today, onshore plants are the norm for processing of natural gas originating from offshore hydrocarbon production wells. The onshore processing however requires pipelines to transport the gas to shore. The pipelines are relatively expensive, often require some form of preliminary offshore processing to bring the gas to pipeline specifications, and pose an inherent security and safety risk, for instance due to the potential of leaks and explosions. These drawbacks increase with increasing length of the required pipeline. Also, onshore facilities require land, with associated costs, potential damage to the natural environment and dealing with local communities.

Floating off-shore hydrocarbon processing plants are known in various forms, including for example floating production storage and off-loading (FPSO) concepts. More recently, various concepts for floating natural gas liquefaction plants (FLNG) have been proposed.

WO2014053314 discloses a floating off-shore hydrocarbon gas processing plant arranged on a floating structure. The plant is typically intended to liquefy the natural gas by cooling, for producing liquefied natural gas (LNG). The LNG can be shipped to customers at selected locations around the world. The structure floats on a body of water above a sea bed, and is anchored to the sea bed via an anchor line attached to an anchor point on the sea bed. A distal end of a water intake hose projects away from the floating structure into the body of water and a proximal end of the water intake hose is connected to the hydrocarbon gas processing plant, to take up water from the body of water and convey the water to the floating structure through the water intake hose. The water intake hose is mechanically connected to the anchor line at multiple locations along the length of the water intake hose.

### BRIEF DESCRIPTION OF THE INVENTION

It is an object of the disclosure to provide an alternative for offshore processing of hydrocarbons.

The application provides a system for offshore processing of hydrocarbons, the system comprising:
- at least one offshore structure, the offshore structure being provided with:
- at least one power plant unit for converting the hydrocarbons to electrical power;
- a cooling water intake system for taking in cooling water from a body of water;
- at least one data centre unit being connected to the at least one power plant unit to be powered by at least part of the electrical power and being connected to the cooling water to be cooled; and
- at least one data connection line for transferring data between the at least one offshore structure and shore.

The system of the disclosure allow synergies between system components which traditionally are not grouped together. Offshore structures have advantages as cooling water at relatively low temperatures is readily available. The cooling water intake required for the gas processing and/or power generation can be used for cooling the data centre, thus limiting overall energy consumption and operating expenditures. Other advantages related to obviating long expensive pipelines for transportation of hydrocarbons, typically natural gas, to an onshore power plant or facility. The expensive pipeline is replaced by a power cable. The system allows a considerable overall reduction in energy consumption, for instance by use of cooling water instead of chilled air to cool the data centre. An additional efficiency gain can be achieved by using the generated power directly at the source. Herein, limiting the distance between the power unit and the data centre limits electricy transport losses, while the data may be transported wirelessly or via optical fibres, using light pulses.

The at least one data connection line may transfer data between the offshore structure and one or more landing points on shore.

In an advantageous embodiment, the disclosure provides a system for offshore processing of hydrocarbons, the system comprising:
- at least one offshore structure, the offshore structure being provided with:
- a power plant unit for converting the hydrocarbons to electrical power;
- a cooling water intake system for taking in cooling water from a body of water;
- a heat exchanger connected to the cooling water for heat exchanging thereof against a heated drinking water stream, to provide a heated cooling water stream and a cooled drinking water stream;
- a desalination unit connected to the heated cooling water stream to provide a drinking water stream and a waste water stream, the desalination unit being connected to the power plant unit to receive a first part of the electrical power;
- at least one data centre unit being connected to the drinking water stream for cooling of data centre components and for discharging the heated drinking water stream, the data centre unit being connected to the power plant unit to receive a second part of the electrical power;
- a water conduit connecting the at least one offshore structure to shore for transporting at least part of the cooled drinking water stream to shore; and
- at least one data connection line for transferring data between the data centre unit and shore.

In an embodiment, the at least one offshore structure is provided with an offloading installation for transport of drinking water via tankers to at least one onshore location.

In an embodiment, the system comprises a power cable connecting the at least one offshore structure to shore to transport a third part of the electrical energy to shore.

According to another aspect, the disclosure provides a method for the use of the system as described above.

### BRIEF DESCRIPTION OF THE DRAWINGS

These and other features, aspects, and advantages of the present disclosure will be apparent from the following detailed description with reference to the accompanying drawings in which like characters represent like parts throughout the drawings, and wherein:
Fig. 1 shows a cross section of a prior art natural gas production facility;
Fig. 2 show a cross section of an embodiment of a system according to the disclosure;
Fig. 3 shows a cross section of another embodiment of a system of the present disclosure;
Fig. 4 shows a perspective view of a detail of yet another embodiment of a system of the present disclosure; and
Fig. 5 shows a side view in cross section of the embodiment of Fig. 4;
Fig. 6 shows a front view in cross section of the embodiment of Fig. 4; and
Fig. 7 shows an exemplary flow scheme of an embodiment of the disclosure.

### DETAILED DESCRIPTION OF THE INVENTION

The present disclosure is directed to a system and method for offshore processing of hydrocarbons. Optionally, the system and method are also suitable for the offshore processing of renewable energy sources. The hydrocarbons comprise, for instance, at least natural gas. The disclosure may be applicable to other hydrocarbons as well, including condensate, or other hydrocarbon liquids. The disclosure Hereinafter, similar features are indicated using the same reference numerals.

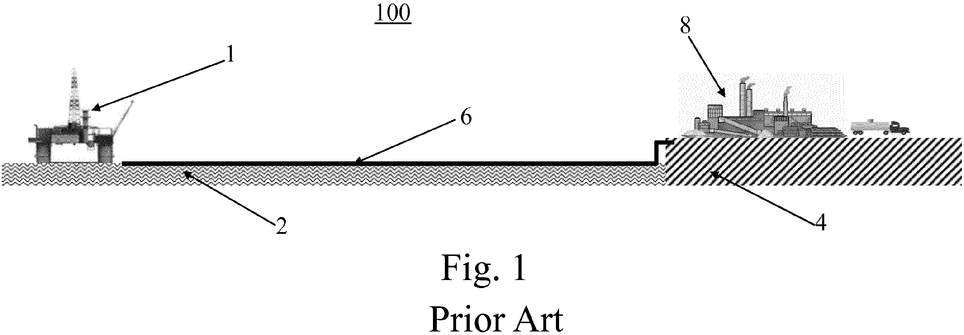

As mentioned in the introduction, onshore plant are the norm for the processing of produced hydrocarbons, even when the hydrocarbons originate from offshore wells. For instance, see Fig. 1, a conventional system 100 for production and processing of hydrocarbons may comprise an offshore production platform 1, located in a body of water 2. The body of water is typically a sea or ocean, but can also be a lake. Water depths may vary from shallow, for instance up to 150 meters, to ultra deep water.

Typically, offshore exploration and development wells are drilled from mobile offshore drilling rigs. Depending on the water depth and remoteness of the location, these "rigs" may be jack-ups (up to 400 feet [120 meters] of water), or semisubmersibles, or drillships (up to 12,000 feet [3.7 km] of water). Jack-ups are bottom-supported units, having legs based on and engaging the bottom of the body of water. Semisubmersibles and drillships are floating units ("floaters"). The ydrocarbons may be produced from similar facilities, or may be replaced with a more suitable offshore structure. Fig. 1 shows a semisubmersible as an exemplary embodiment.

The hydrocarbons produced from the platform 1 are transported to shore 4, typically via a pipeline 6. An onshore facility 8 may store and process the hydrocarbons, and distribute the processed hydrocarbons. Some preliminary gas treatment is often performed offshore, on platform 1, to separate hydrocarbon fluids and to bring the streams up to standards which are acceptable for pipeline specs.

As with hydrocarbon processing, onshore plants are the norm for both power-production (for instance gas fired power plants to produce electricity) and water (for instance desalination, river-water filtration or well-water production).

Also generally located onshore are ever larger data-centres. A data center is a facility used to house computer systems, and for instance also associated components, such as telecommunications and storage systems. It generally includes redundant or backup power supplies, redundant data communications connections, environmental controls (e.g., air conditioning, fire suppression) and various security devices. Large data centers are industrial scale operations using as much electricity as a small town. Data centres herein typically refer to computer servers for large scale storage of data for multiple clients. In a recent estimate by IBM, operating costs of these data centres may be up to 3 to 5 times higher than the capital expenditure to establish the data centre. Herein, an estimated 75% of the operating costs may be due for required energy to power the data centre. Moreover, of the total costs, 28 to 30%, i.e. in the order of half the costs for energy, may be required for cooling capacity.

Basically, the cooling capacity required to keep the temperature of the stacks of computer servers within a safe operating range is gigantic. The data-centres are typically cooled by airconditioning systems, which require close to 50% of the energy intake. On its website, Google, one of the largest operators of data centres, claims that their data centers use 50% less energy than the typical data centre, for instance by raising the temperature of the servers to 80°F (27°C), by using outside air for cooling, and by building custom servers.

The use of water for cooling is explored yet limited. Some companies are trialling at the moment, for instance Green Revolution Cooling of Austin, Texas. Other companies include Microsoft, Google, and Nautilus.

But, if a water leak occurred, the positive pressure would force water out into the heart of the computer, causing severe damage to computer components.

IBM claims that water cooling has matured to a point where leakage should not be the problem that it once was. For example, data centres can use rear door heat exchanges as self-contained systems, such that if there is a leak, it is all contained within the system with no risk of the water getting to any electrical equipment. Here, the rear of a 19-inch server rack is replaced with a heat exchanger through which chilled water is pumped. Even as a passive system (i.e. no forced air used), IBM and others claim that such a system can remove 60% of the heat from a 33 kW high-density rack. Used within a self-contained sealed rack, rear door heat exchangers can provide considerable savings.

Another approach is to use highly targeted water cooling, in which metal pads (generally copper or even gold-plated copper for additional thermal efficiencies) with micro-channels are used to replace the standard cooling fins used on CPUs. Pure water (no dissolved solids or gases) is passed through the micro-channels, removing heat directly from the CPUs (central processing units). Often the heated water used for cooling can be used in other parts of the building as output at temperatures that are high enough to heat water.

So in practice, the use of water for cooling is explored yet limited, for instance due to local constraints such as the limited ability for heating up a river or lake thus limiting the volume of disposable heated water or due to the novelty of such for the IT industry.

Benefits of an offshore development for some products, such as FLNG, are widely recognized. Some concepts of offshore power generation and power supply and offshore desalination have been developed in the past, but always in isolation. Primarily due to technical (for instance limitations of available power supply) or economic constraints, offshore concepts have either not been executed or were developed uneconomically at very low capacity to provide supply in reponse to a sudden urgent demand.

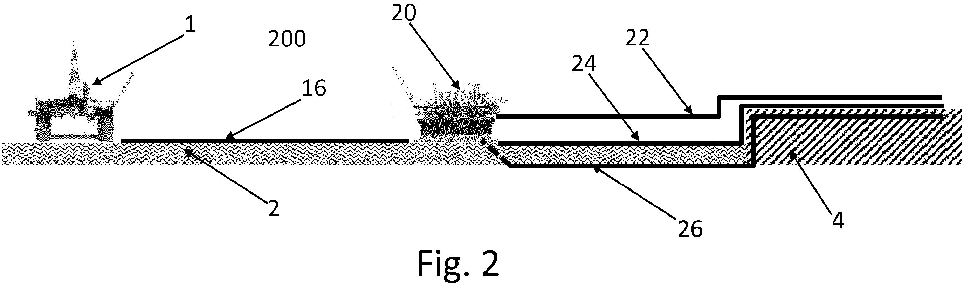

Fig. 2 shows a system 200, comprising an offshore processing structure 20. Offshore herein means that the structure 20 is located off shore, in the body of water 2. Pipeline 16 is connected to the offshore structure 20 and to the production platform 1. Hydrocarbons produced at the production platform can be supplied to the offshore structure 20.

The offshore processing structure 20 may be a floating structing, such as a vessel. In another embodiment, the offshore structure 20 may be a gravity based structure, being at least partly supported on the bottom of the body of water. The bottom herein refers to, for instance, the seabed.

The offshore processing structure 20 may comprise processing facilities for the processing of hydrocarbons. The processing facilities may comprise, for instance, facilities for: the production of electricity; the production of drinking water (from salt water); and/or for data management. The facility for data management typically is a data centre.

The offshore structure 20 may be connected to shore 4 via one or more of: an electricity cable 22 for the transport of electricity; a water conduit 24 for the transport of drinking water; and/or a data connection line 26 for the transport of data.

The electricity cable 22, water conduit 24 and data connection line 26 can transport electricity, water, and data respectively between the structure 20 and respective onshore facilities, or vice versa. The at least one data connection line 26 may comprise, for instance, fibre-optic infrastructure suitable for use in an offshore environment. The latter may include one or more of fibre-optic cables, transducers, receivers, transmitters, and/or signal amplifiers.

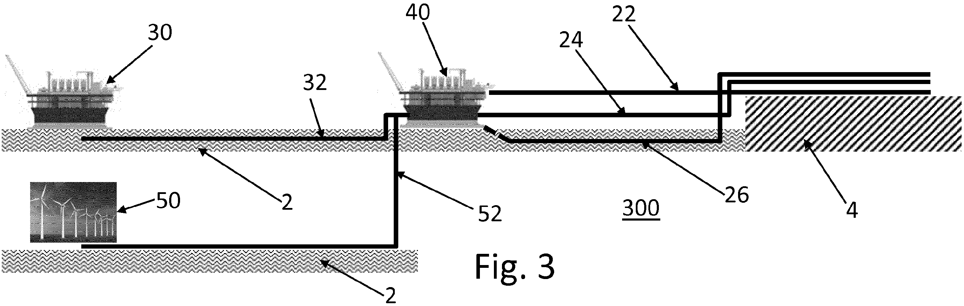

In another embodiment, shown in Figure 3, a system 300 comprises a first offshore structure 30 for the processing of hydrocarbons to produce power, typically electricity. The offshore structure 30 may include production facilities for the production of hydrocarbons. Thus, the offshore structure 30 may comprise facilities for the production of hydrocarbons, and for the production of electricity using the produced hydrocarbons. The structure 30 may be a floating vessel. Alternatively, the structure 30 may be any hydrocarbon production facility, such as a gravity based structure or semisubmersible.

The first offshore structure 30 is connected to a second offshore structure 40 by power cable 32. The power cable 32 can transport power, typically electricity, between the first structure 30 and the second structure 40.

In an optional embodiment, an alternative or additional power source 50 is connected to the second offshore structure 40 by second power cable 52. The alternative power source may comprise, at least, a renewable energy source, such as a wind farm. Wind power or wind energy is the use of wind farms to harvest wind energy to generate electricity. In an embodiment, the wind farm may be constructed offshore, usually on the continental shelf, to limit land use and impact on onshore activities.

The second offshore structure 40 is intended for the production of desalinated water and/or for locating one or more server farms. Structure 40 may be connected to shore 4 via, at least, one or more of a water conduit or pipeline 24 for the transport of drinking water (potable water) and/or a data cable 26 for the transport of data. Other means of evacuation of drinking water, such as offloading to tankers or large carriers, are conceivable but are not represented in the drawings. The water conduit 24 and data cable 26 can transport water and data respectively between the structure 40 and respective onshore facilities.

In an optional embodiment, the second offshore structure may be connected to land via power cable 22. The power cable 22 allows to transport a potential surplus of electrical power to shore 4. Alternatively, the first offshore structure 30 may be connected to shore directly via another power cable (not shown), allowing surplus electricity to be transported to customers on shore directly.

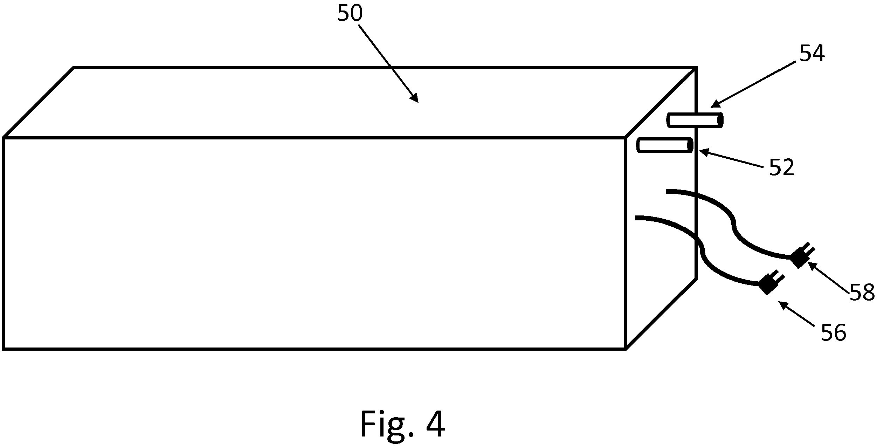

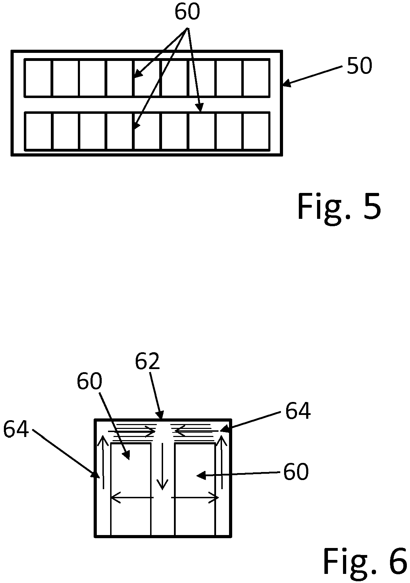

Figures 4 to 6 show details of an embodiment for a data centre section 50. The data centre section 50 may have dimensions corresponding to one of the container dimensions as stipulated in DIN/ISO 668 or DIN 15190, Part 1. Examples are provided in the following table:

| | Length | Length | Length | Width | Height | Height |
|---|---|---|---|---|---|---|
| Dimensions (foot) | 20 | 40 | 45 | 8 | 8'6" | 9'6" |
| Dimensions (mm) | 6058 | 12192 | 13716 | 2438 | 2591 | 2896 |

The data centre section 50 may be provided with a cooling water inlet 52 and a cooling water outlet 54. In addition, the data centre section may be provided with a power connection 56 and a data cable connection 58. The cooling water inlet and outlet function as input and outlet for cooling water. The power connection typically is an electrical power connection. The data cable connection can transport data to and from the data centre section. The data cable connection 58 may typically connect the data centre section 50 to other data centre sections, and/or to the data cable 26.

The data centre section may house, for instance, a multitude of computer unit 60. Each computer unit may be a computer system including associated data storage systems. Potentially one or more of the computer units may also include telecommunications systems. The computer units may be stacked, filling the internal space of the data centre section 50 in width, height and/or length.

Cooling water supply channels 62 and cooling water discharge channels 64 may be provided adjacent the stacks of computer units 60. Herein, cooling water supply channels 62 are connected to the cooling water inlet 52 for the supply of relatively cool water. Cooling water discharge channels 64 are connected to the cooling water outlet 54 for the discharge of cooling water.

The computer units may be provided with suitable cooling structures (not shown), to enable exchange of heat between the computer units and the cooling water. The cooling structures may include, for instance, fins made of heat conductive material, extending into at least the cooling water supply channels and potentially also into the discharge channels 64.

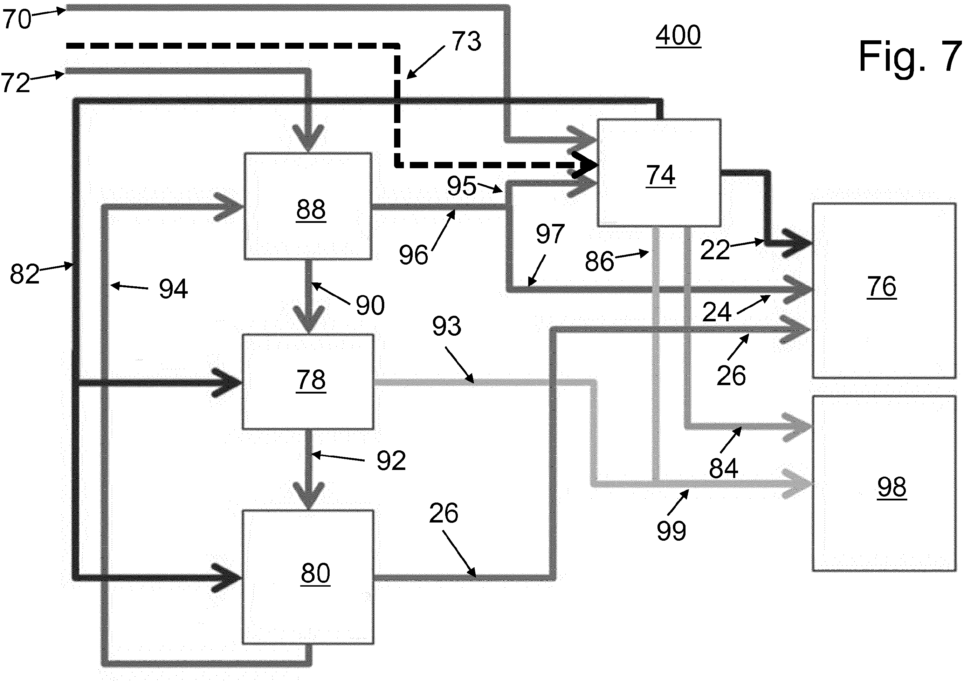

Fig. 7 shows a flow scheme of an exemplary embodiment of a system 400 combining multiple functional blocks to improve the efficiency.

Inputs to the system 400 are hydrocarbons 70 and cooling water 72. The hydrocarbons 70 typically comprise natural gas, but any type of available hydrocarbon fuel may be used. The cooling water typically comprises salt water, from the sea or ocean.

The cooling water 72 is taken in - for instance into any of the structures 20, 30, 40 - via water intake risers. For details of possible structures and embodiments of suitable water intake systems, see for instance US-7,318,387 or WO-2014/053314.

The hydrocarbons are provided to a power plant unit 74. The power plant section 74 comprises equipment for converting the hydrocarbons to power, for instance electricity. The power, typically electricity, can be provided to one of more of: At least one customer 76; water desalination unit 78; data centre unit 80. The power plant unit 74 is linked to one or more of these outlets via, for instance, power line 22 and/or power line 82. Waste outputs of the power plant unit 74 may include, for instance, one or more of CO2 stream 84 and waste water stream 86.

The cooling water 72 is provided to, for instance, heat exchanger 88. Heated cooling water 90 may be provided to, for instance, desalination unit 78. The desalination unit 78 can output drinking water 92.

The desalination unit 78 can convert at least part of the (relatively salty) heated cooling water 90 to drinking water 92. Herein, the desalination unit may be powered via power line 82. The desalination unit may output a remainder part of the heated cooling water 90 as waste water stream 93. Waste water stream 93 typically includes brine, i.e. salt water having a salt content (significantly) exceeding the salt content of the cooling water 72.

Optionally, at least part of the drinking water stream 92 can be provided to data centre unit 80. The data centre unit 80 takes in the drinking water stream 92 and uses the drinking water for cooling of components, such as data storage and data processing components. See, for instance, Figs. 4-6 and the corresponding description. The data centre unit 80 can be connected to the power cable 82, for powering the data centre unit.

Heated drinking water 94 can be fed back to the heat exchanger 88 for heat exchange with the cooling water stream 72. Cooled drinking water stream 96 may be provided, for instance, to customer(s) 76 and/or to the power plant unit 74. The power plant unit may use the water 96 as make-up water. Makeup water herein means water fed to the unit to replace that which is lost. For example, water fed to a boiler to replace that lost as steam or condensate; water fed to a cooling tower to replace that lost by evaporation, drift, or other causes.

Waste streams of the system 400 comprise, for instance, CO2 stream 84 and waste water streams 86, 93. Waste streams have to be discarded, generally indicated by discharge unit 98. In practice, CO2 may be, for instance, converted, stored underground (e.g. by Carbon Capture and Storage (CCS)), used in green houses to stimulate plant growth, and/or released into the air. The brine stream 93 may be combined with the water stream 86, providing combined waste water stream 99. The combined waste water stream 99 typically has a lower salt concentration than the brine 93, potentially allowing to discard of the combined waste water stream into the body of water 2. Alternatively, the combined waste water stream 99 may be treated by appropriate treatment units, potentially included in the discharge unit 98.

In a practical embodiment, hydrocarbons 70 are produced and provided to the power plant unit 74. The power plant unit may function as a fossil-fuel power station comprising, for instance, a steam turbine generator or a combustion turbine. The combustion turbine works well in the case of a natural gas-fired power plant unit. The hydrocarbons may produce heat by burning, to procude steam in a steam boiler. The steam may drive a steam turbine and a generator that then produces electricity.

Depending on the hydrocarbons, waste products of combustion may include ash, sulphur dioxide, nitrogen oxides and/or carbon dioxide. Some of these gases can be removed from the waste stream to reduce pollution.

Thermoelectric power plants boil water to create steam, which then spins turbines to generate electricity. The heat used to boil water can come from burning a fuel, for instance derived from the hydrocarbon stream 16. Once steam has passed through a turbine, it must be cooled back into water before it can be reused to produce more electricity. Colder water cools the steam more effectively and allows more efficient electricity generation.

The power plant unit may have a conversion efficiency in the order of 50%. Typical thermal efficiency for utility-scale electrical generators may be around 33% for an oil-fired power plant, and 55 to 60% (LHV) for a combined-cycle gas-fired power plant. Gas turbines in the simple cycle mode, with only Gas turbines running, may have an efficiency of 32 % to 38 %. An important parameter that dictates the efficiency is the maximum gas temperature possible. The latest Gas Turbines with technological advances in materials and aerodynamics can have efficiencies upto 38 %. In the combined cycle mode, Gas turbines can run at 60 % efficiency.

Herein, the quantity known as lower heating value (LHV) [also referred to as net calorific value (NCV) or lower calorific value (LCV)] is determined by subtracting the heat of vaporization of the water vapor from the higher heating value. This treats any H2O formed as a vapor. The energy required to vaporize the water therefore is not released as heat.

Water intake of the power plant unit 74 may be in the order of 30,000 to 500,000 metric tonne per day, for instance about 200,000 to 350,000 tonne per day (200 to 350 kilo tonne per day). Thereof, the majority can be (salt) cooling water 73, which is typically taken in directly from the body of water 2. The cooling water stream 73 is used to cool the steam in the generator. Vaporization of the cooling water and deposits of salt and minerals are limited as the temperature increase of the cooling water stream 73 is limited due to the relatively high flux. Therefore, salt water can be used for cooling water stream 73.

In addition, the power plant unit 74 may require in the order of 30 to 500 metric tonne per day of potable water 95, for instance about 200 to 350 tonne per day. The water stream 95 is used as makeup water, to make up for water in the electricity generator cycle which may be lost. Since there is continuous withdrawal of steam and continuous return of condensate to a boiler in the power plant unit, losses due to blowdown and leakages have to be made up to maintain a desired water level in the boiler steam drum. For this, make-up water 95 is added to the boiler water system. Hardness in the make-up water to the boiler will form deposits on the tube water surfaces which may lead to overheating and failure of the tubes. Thus, the salts have to be removed from the water, which is done by the water demineralising treatment plant 78.

The waste water 86, which is the heated cooling water 73, may have a temperature in the order of 15 to 25°C, for instance about 20°C. This temperature can be controlled by changing the flux of the cooling water 73 relatively to the cooling requirements of the power plant unit 74.

Output power of one power plant unit 74 to the customer 76 may be in the order of 500 to 1000 MW, for instance about 600 MW. Power consumption of the other components of the system 400, provided via power line 82, may be in the order of 60 to 80 MW, for instance about 75 MW.

Intake of cooling water 72 may be in the order of 70,000 to 90,000 metric tonne per day, for instance about 80,000 tonne per day. Intake of cooling water stream 72 may be combined with cooling water stream 73 via the same, or a combined, cooling water intake system (not shown).

Temperature of the cooling water 72, 73 may be in the range of 4°C to 10°C. The body of water 2 is preferably relatively deep and large. To obtain water in the 3 to 6°C (37 to 43°F) range, a depth of 50 m (160 ft) to 70 m (230 ft) is generally required, depending on the local conditions.

The heat exchanger 88 may take in drinking water 94 at a temperature in the order of 40 to 45°C. The drinking water 94 may come in at a rate of 70,000 to 80,000 tonne per day. Cooled drinking water 96 may be at a temperature in the order of 20°C to 30°C, for instance about 25°C. In the range of 20 to 500 tonne per day may be required for makeup water stream 95, provided to the power plant unit 74. The required amount of makeup water 95 may depend on the type, the size, and/or the power capacity (electrical output power, e.g. in MW) of the power plant unit. The make up water stream may be in the lower range (for instance 30 to 40 tonne per day) and in a higher range (for instance in the order of 200 to 350 tonne per day).

The remainder 97 of the cooled drinking water may be provided to the at least one customer 76. The drinking water stream 97 can be in the order of 70,000 to 80,000 tonne per day.

The heated cooling water 90 has a temperature in the order of 15°C to 25°C, for instance about 20°C.

The desalination unit 78 may consume power from power line 82 in the order of 10 to 60 MW, for instance about 16 MW. The desalination unit 78 may produce in the order of 70,000 to 80,000 tonne per day of drinking water 92, for instance about 75,000 tonne per day. Temperature of the drinking water 92 may be about 15-25°C, for instance about 20°C. The desalination unit 78 may produce in the order of 8,000 to 9,000 tonne per day of brine 93, for instance about 8,300 tonne per day. The brine 93 may have a temperature of, for instance, about 20°C. Herein, the desalination unit 78 may have a concentration factor in the order of 80 to 95%, for instance about 90%. Herein, concentration factor means that the salt concentration in the waste stream 93 is a certain percentage higher than the salt concentration in the water stream 90.

A desalination process used in the desalination unit 78 may include vacuum distillation. This is essentially the boiling of water at less than atmospheric pressure and thus a much lower temperature than normal. This is because the boiling of a liquid occurs when the vapor pressure equals the ambient pressure and vapor pressure increases with temperature. Thus, because of the reduced temperature, low-temperature "waste" heat from electrical power generation or industrial processes can be minimized. In a preferred embodiment, the desalination process uses membranes to desalinate, principally applying reverse osmosis technology. The reverse osmosis process uses a semipermeable membrane and pressure to separate salts from water. Reverse osmosis plant membrane systems typically use less energy than thermal distillation, which leads to a reduction in overall desalination costs.

The data centre unit 80 may have a power rating in the order of 50 to 200 MW, for instance about 100 MW. Power rating herein refers to the power consumption of a stand-alone data centre. Using the system of the invention, an efficiency gain can be achieved, by using the available water as cooling water. The efficiency gain may be in the order of 25 to 50% compared to a stand alone data centre, for instance about 40%. Power consumption from power line 82 therefore may be about 25% to 50% less than the power rating. In a practical embodiment, power consumption of the data centre unit 80 via power line 82 may be in the order of 25 to 150 MW.

The heated drinking water 94 may have a temperature in the order of 30 to 50°C, for instance about 40°C.

The combined waste water stream 99 may be in the order of 7,500 to 8,500 tonne per day at about 20°C.

Synergies and economics of the system of the present disclosure may depend on specifics of the arrangement.

For instance, a local authority may determined at what price drinking water may be sold.

As an example, the Energy and Water Utilities Regulatory Authority (EWURA) of Tanzania sets the prices of drinking water. For people with their own water meter, the price may be set at 300 to 390 shillings per cubib metre (TZS/m3). For people who rely on public standpipes and water kiosks, the tariff is 20 shillings (TZS) per 20 liter or the equivalent of 1 shilling per liter.

Water may be transported to shore per pipeline or by boats / tankers.

Explosion-safety design-constraints may drive Gas-to-Power, Gas-to-Water and/or Gas-to-Bits to be on a separate vessel or on a separate section of a shared vessel. Herein, Gas-to-Bits and Gas-to-Water refer to a combined system, as shown for instance in Figures 2 and 3, wherein produced hydrocarbons or natural gas is converted to power which is used to produce drinking water and/or to cool a data centre. Gas-to-power refers to the conversion of hydrocarbons or natural gas to power, typically electricity.

Waste streams comprising brine 99 and CO2 84 may have value to other downstream processes and may be provided with their own separate transport-lines.

Valorising synergies of embodiments of the system of the present disclosure, for instance between Gas-to-Power (GtP), Gas-to-Water (GtW) and/or Gas-to-Bits (GtB), may be in the areas of:
1. Co-location: combining all three facilities on at least one offshore structure reduces space requirements. Since part of the electricity produced by GtP will be used by GtW and GtB, a considerable reduction is achieved in transportation infrastructure for electricity and/or gas, reducing required CAPEX.
2. Energy optimisation: using the heated cooling water waste stream 94 of the data centre as an energy source for Gas-to-Water to heat up the sea-water (in heat exchanger 88) before entering the desalination unit 78. Eliminating heat-generation and dissipation at individual units considerably reduces energy consumption and CO2 output.
3. Feedstock re-utilisation: utilising de-salinated water 92 as cooling medium (for instance for the data centre 80) instead of sea-water reduces the complexity of the heat-cooling infrastructure required for the GtP and GtB section. The desalinated water 94 can still be used as potable water after cooling the data centre and does not need to be disposed of.
4. Design-simplification for maintenance optimisation: starting from the basis of a Normally Unmanned Facility principle, the combined facility 400 can be designed to allow for remote operation and only require limited utility maintenance onboard of the offshore structures 20, 30, 40. This considerably reduces facility requirements to locate personnel and related costs (OPEX). Implicit to this principle is that most complex work is done onshore (supervision, planning, assembly, overhauls, etc). Transportation and marshalling onboard may be simplified by using containerised modules (see, for example, Figs. 4-6).
5. Feedstock flexibility. Utilising natural gas or other hydrocarbons combined with renewable energies (primarily wind farm 50, see Fig. 3) as energy feedstock eliminates the dependency on a single energy source. It also may drastically reduce the CO2 footprint of the facility while maintaining high reliabilty and availability. For instance, renewable energy and hydrocarbons (for instance natural gas) may be complementary swing producers of energy, wherein the hydrocarbons compensate for the potentially variable nature of the renewable energy source 50.
6. Production stability. The synergy approach allows for shifting production-focus to follow peak-demand:
   Electricity (day-time for offices & air conditioning, plus the data centre 80); water (adjacent to local office hours: early morning and late evening). To make use of renewable energy when available (wind / solar) and/or utilising the off-peak production from gas, electricity can be used to keep producing water and buffer the overnight production of drinking water in storage containers (not shown).
7. Explosion-safety. Instantly converting hydrocarbons, especially natural gas, into electricity considerably reduces the design-constraints regarding the explosion safety barriers of the system.
8. The constraints on gas treatment are also reduced since gas quality required for pipeline transportation is more demanding than Fuel Gas used in offshore turbines for power generation.

Additional observations and advantages of the system of the disclosure may include:
- The present invention opens new horizons for the commercialisation of products (such as data management and/or drinking water supply) and flexibility of supply. The offshore location improves the security of server farms and allows connections with different landing points onshore. Offshore power allows power distribution to different regions or countries from one central location. Offshore desalination opens a new market for trading water in large cargo vessels, supplying cities, countries or industries globally with fresh water on demand;

- Generating a required relatively energy-intensive commodity (such as bits or desalinated water) in-situ rather that first transporting energy to generate the product onshore;
- Constructability: The modular design of the embodiments of the disclosure may provide significant cost savings. The modular design is efficient and allows for accelerated construction.
- Combining the data centre, drinking water supply and power production on one or more vessels offshore provides synergies that unlock economic constraints of each, when considered independently. For example, offshore infrastructure, such as mooring system, water intake system, living quarters for staff, logistics, utilities, and staff, etc. can be combined. Combining multiple functions allows server farms, water generation and power to be generated offshore and open a new range of benefits (such as modular construction, no transportation of energy) or elimination of onshore related constraints (such as environmental permits, dealing with local communities, access to land, security, supply of power, local workforce capabilities, improved resistance and safety in case of an earthquake or tsunami, relatively straightforward and cost efficient discharge of waste water or brine, etc.

Synergies of the system of the present disclosure have been confirmed. Different sections of the system can be designed so that they are proportional and within each other's operating envelope.

Synergies include, but are not limited to:
Gas-to-Power provides an optional synergy on using desalinated water, yet a relatively small flow;
Gas-to-Water and Gas-to-Bits have a relatively strong synergy by sharing a water stream for heat recycling;
Gas-to-Water and Gas-to-Bits may tune peak-production to optimize utilization of electricity versus demand;
Explosion-safety design-constraints or flexibility requirements (disconnection and re-location) may drive Gas-to-Water and Gas-to-Bits to be on a separate barge (Fig. 3) or on a separate section of a shared barge (not shown).

Brine and CO2 may have value as feedstock for other downstream production facilities.

CO2 for instance may be provided to greenhouse to support plant growth. Also, the carbon dioxide can be injected into or next to producing hydrocarbon wellbores to enhance recovery of hydrocarbons. For instance, the CO2 may be used to enhance oil or gas recovery from any of the wells of production platform 1 or offshore structure 30.

A use for the brine waste stream is saltcrete, which is put into an asphalt mixture for making roads. It may also be disposed by desalination plants by releasing it into streams and rivers to end up in the ocean, where it will mix into the already salty seawater and the resulting salinity increase will be so slight that it will have insignificant effect on the ecosystem. When the desalination unit uses reverse osmosis, for instance, this may produce a very salt concentrated brine waste stream. Then, the super concentrated brine may be dried out, the water can be evaporated, and the salt product can be distributed for commercial use. Waste water, such as brine, of 20°C may be acceptable for overboard disposal.

The present disclosure is not limited to the embodiments as described above, wherein many modifications are conceivable within the scope of the appended claims. Features of respective embodiments may for instance be combined.

## Claims

1. A system for offshore processing of hydrocarbons, the system comprising:
- at least one offshore structure, the offshore structure being provided with:
- a cooling water intake system for taking in cooling water from a body of water;
- at least one power plant unit for converting the hydrocarbons to electrical power;
- at least one data centre unit being connected to the at least one power plant unit to be powered by at least part of the electrical power and being connected to the cooling water to be cooled; and
- at least one data connection line for transferring data between the at least one offshore structure and shore.

2. The system of claim 1, the at least one offshore structure being provided with at least one desalination unit for desalinating the cooling water and being coupled to the data centre unit for providing drinking water to the at least one data centre unit for cooling thereof.

3. The system of claim 2, the at least one desalination unit being powered by at least the electrical power.

4. The system of claim 2, the system comprising a heat exchanger for receiving the cooling water, and for heating the cooling water versus heated water output from the data centre unit.

5. The system of claim 1, the system being connected to a source of renewable electrical power, the renewable electrical power being combined with the electrical power to power one or more of the at least one desalination unit and the at least one data centre unit.

6. The system of claim 1, the system comprising a first offshore structure and a second offshore structure, the second offshore structure being separate from the first offshore structure.

7. The system of claim 6, the first offshore structure being a hydrocarbon production platform and being connected to the second offshore structure via a pipeline for providing the hydrocarbons to the second offshore structure.

8. The system of claim 6,
the first offshore structure being provided with:
- hydrocarbon production facilities for producing hydrocarbons; and
- the at least one power plant unit for converting the hydrocarbons to electrical power;
the system comprising:
- a power cable to transport at least part of the electrical power from the first offshore structure to the second offshore structure;
the second offshore structure being provided with:
- the at least one cooling water intake system for taking in cooling water from a body of water; and
- the at least one data centre unit being powered by at least part of the electrical power; and
- the at least one data line for transferring data between the second offshore structure and shore.

9. The system of claim 8, the second offshore structure being provided with the at least one desalination unit.

10. The system of claim 1, the at least one offshore structure being provided with at least one power cable to transport another part of the electrical power to shore.

11. The system of claim 1, the at least one data centre unit comprising:
- a container shaped stackable housing;
- a number of data centre components arranged in the housing; and
- cooling water conduits for cooling the data centre components.

12. The data centre unit of claim 11, the housing having the shape and dimensions of a container, and being stackable with other data centre units to form stacked data centre units.

13. A system for offshore processing of hydrocarbons, the system comprising:
- at least one offshore structure, the offshore structure being provided with:
- a power plant unit for converting the hydrocarbons to electrical power;
- a cooling water intake system for taking in cooling water from a body of water;
- a heat exchanger connected to the cooling water for heat exchanging thereof against a heated drinking water stream, to provide a heated cooling water stream and a cooled drinking water stream;
- a desalination unit connected to the heated cooling water stream to provide a drinking water stream and a waste water stream, the desalination unit being connected to the power plant unit to receive a first part of the electrical power;
- at least one data centre unit being connected to the drinking water stream for cooling of data centre components and for discharging the heated drinking water stream, the data centre unit being connected to the power plant unit to receive a second part of the electrical power;
- a water conduit connecting the at least one offshore structure to shore for transporting at least part of the cooled drinking water stream to shore; and
- at least one data connection line for transferring data between the data centre unit and shore.

14. The system of claim 13, comprising a power cable connecting the at least one offshore structure to shore to transport a third part of the electrical energy to shore.

15. A method for offshore processing of hydrocarbons, using the system of claim 1.
